# EUROPEAN PATENT APPLICATION

(11) **EP 4 749 392 A1**
(43) Date of publication of application: **27.05.2026**
(21) Application number: 25218130.0
(22) Date of filing: 24.11.2025
(51) Int. Cl.: G06F 1/16, H04M 1/02

(54) **ROLLER HINGE WITH FRICTION ELEMENTS**

(30) Priority: 25.11.2024 US 202463724826 P; 14.08.2025 US 202563863769 P; 21.10.2025 US 202519364978
(71) Applicant: Apple Inc., Cupertino, CA 95014 (US)
(72) Inventor: ROBINSON, Kevin M., Sunnyvale (US); HAMEL, Bradley J., Portola Valley (US); PARK, Daniel C., Redwood City (US); STRYKER, James A., Campbell (US); WANG, Lei, Sunnyvale (US); KRAHN, Scott J., Cupertino (US)
(74) Representative: Froud, Christopher Andrew

(57) **Abstract**

An electronic device (10) may include a flexible display (14) mounted to a foldable housing. The foldable housing may include first and second housing portions (12-1, 12-2) coupled by a hinge (30) that is aligned with the bend axis (28). The hinge (30) may include rollers (48) and interdigitated friction leaves (68) that rotate about multiple axes of rotation. The hinge (30) may include shafts that are received by the leaves and that are each aligned with a respective one of the axes of rotation. Some of the leaves (68) may include gears (78) for imposing synchronous motion of the first and second housing portions (12-1, 12-2), while other leaves may include hard stop structures (80) for imposing an open position hard stop and a closed position hard stop. In some arrangements, the leaves (68) may include a vertical slot (88) that receives a mutual pin and provides both synchronous motion functionality and hard stop functionality.

## Description

This application claims priority to U.S. patent application No. 19/364,978, filed October 21, 2025, U.S. provisional patent application No. 63/863,769, filed August 14, 2025, and U.S. provisional patent application No. 63/724,826, filed November 25, 2024.

### Field

This relates generally to electronic devices and, more particularly, to electronic devices with displays.

### Background

Electronic devices often have displays. Portability may be a concern for some devices, which tends to limit available real estate for displays.

### Summary

An electronic device may include a flexible display having first and second display portions that rotate relative to one another about a bend axis. The flexible display may be mounted to a foldable housing having first and second housing portions coupled by a hinge that overlaps the bend axis. The foldable housing may be operable in a flat (e.g., open) state and a folded (e.g., closed) state.

The hinge may include interdigitated friction leaves that rotate about multiple axes of rotation. The hinge may include shafts that are received by the leaves and that are each aligned with a respective one of the axes of rotation of the hinge. The interdigitated leaves may produce torque through axial friction along the axis of each shaft.

Some of the leaves may include gears for driving synchronous motion of the first and second housing portions, while other leaves may include hard stop structures for preventing overtravel in the open and closed directions.

In some arrangements, the leaves may include first and second leaves with an opening and a third leaf with vertical slot aligned with the openings in the first and second leaves. A mutual pin may be inserted through the openings of the first and second leaves and through the vertical slot of the third leaf. The pin and vertical slot may provide both synchronous motion functionality and hard stop functionality.

If desired, the hinge may include a set of parallel rollers coupled between the first and second housing portions. The interdigitated friction leaves may be located between the rollers and the display.

The hinge module may include friction reducing cams that help reduce friction in the hinge module as the device approaches a fully open state (e.g., where first and second housing portions are separated by an angle of 180 degrees). Detent cams may be used instead of or in addition to friction reducing cams. Detent cams may be used to produce an opening torque to help force the device into a fully open state. Detent cams may produce opening torque at other angles (e.g., when the device is closed so that the device is easier to open). If desired, friction leaves may include slots with cantilevers that apply a force to timing pins to help push the device into a fully open state. Arrangements in which friction reducing cams and/or detent cams are used to provide friction relief and/or closing torque as the device is being closed may also be used, if desired.

If desired, detent cams may be configured to generate a torque and to reduce a spring load on the friction leaves to reduce friction in the hinge module. With this type of arrangement, detent cams perform both the function of a friction reducing cam (by reducing friction in the hinge module) and a detent cam (by generating a torque). When detent cams are used in this way, there is still some residual friction in the hinge module due to the residual axial load on the friction leaves.

### Brief Description of the Drawings

FIG. 1 is a schematic diagram of an illustrative electronic device in accordance with some embodiments.
FIG. 2 is a perspective view of an illustrative electronic device with a display in accordance with some embodiments.
FIG. 3 is a side view of an illustrative electronic device in accordance with some embodiments.
FIG. 4 is a side view of an illustrative electronic device having a foldable housing and a foldable display in a flat state in accordance with some embodiments.
FIG. 5 is a side view of the electronic device of FIG. 4 in a folded state in accordance with some embodiments.
FIG. 6 is a perspective view of an illustrative hinge assembly that includes parallel rollers coupled to hinge modules with interdigitated friction leaves in accordance with some embodiments.
FIG. 7 is a top view of an illustrative hinge module that may be used in the hinge assembly of FIG. 6 in accordance with some embodiments.
FIGS. 8 and 9 are front views of an illustrative pair of friction leaves that may be used in the hinge modules of FIGS. 6 and 7 with gears for driving synchronous motion of first and second housing portions in accordance with some embodiments.
FIG. 10 is a perspective view of an illustrative pair of friction leaves that may be used in the hinge modules of FIGS. 6 and 7 with hard stop structures for providing an open hard stop position and a closed hard stop position in accordance with some embodiments.
FIGS. 11 and 12 are front views of an illustrative set of friction leaves that may be used in the hinge modules of FIGS. 6 and 7 with openings and vertical slots that receive pins for driving synchronous motion of first and second housing portions and for providing hard stops in the open and closed positions in accordance with some embodiments.
FIG. 13 is an exploded perspective view of a hinge module that includes friction leaves of the type shown in FIGS. 11 and 12 in accordance with some embodiments.
FIG. 14 is a front view of an illustrative friction leaf having an opening formed from one or more cantilevered arms and configured to receive a pin in accordance with some embodiments.
FIG. 15 is an exploded perspective view of a hinge module that includes double-headed friction leaves for receiving shafts and pins as discussed in connection with FIGS. 11 and 12 in accordance with some embodiments.
FIG. 16 is an exploded perspective view of an illustrative hinge module having friction reducing cams that load and unload friction leaves as the electronic device moves between folded and unfolded states in accordance with some embodiments.
FIG. 17 is a side view of illustrative friction reducing cams of the type shown in FIG. 16 showing how the friction reducing cams are positioned when the electronic device is in a folded, fully closed state in accordance with some embodiments.
FIG. 18 is a side view of illustrative friction reducing cams of the type shown in FIG. 16 showing how the friction reducing cams are positioned when the electronic device is in an unfolded, fully open state in accordance with some embodiments.
FIG. 19 is a side view of a portion of an illustrative hinge module having friction reducing cams and a movable sleeve that is used to load and unload friction leaves as the electronic device moves between folded and unfolded states in accordance with some embodiments.
FIG. 20 is a side view of illustrative friction reducing cams of the type shown in FIG. 19 showing how the friction reducing cams are positioned when the electronic device is in a folded, fully closed state in accordance with some embodiments.
FIG. 21 is a side view of illustrative friction reducing cams of the type shown in FIG. 19 showing how the friction reducing cams are positioned when the electronic device is in an unfolded, fully open state in accordance with some embodiments.
FIG. 22 is a side view of illustrative detent cams configured to produce an opening torque as the electronic device moves into an unfolded state in accordance with some embodiments.
FIG. 23 is a side view of a portion of an illustrative hinge module having detent cams that produce opening torque and friction reducing cams that reduce a load on friction leaves as the device approaches an unfolded state in accordance with some embodiments.
FIG. 24 is a side view of an illustrative friction leaf having a detent feature that produces an opening torque in accordance with some embodiments.
FIG. 25 is a side view of illustrative friction leaves that include press fit holes for receiving timing pins in accordance with some embodiments.

### Detailed Description

Electronic devices may be provided with displays. Displays may be used for displaying images for users. Displays may be formed from arrays of light-emitting diode pixels or other pixels. For example, a device may have an organic light-emitting diode display or a display formed from an array of micro-light-emitting diodes (e.g., diodes formed from crystalline semiconductor dies).

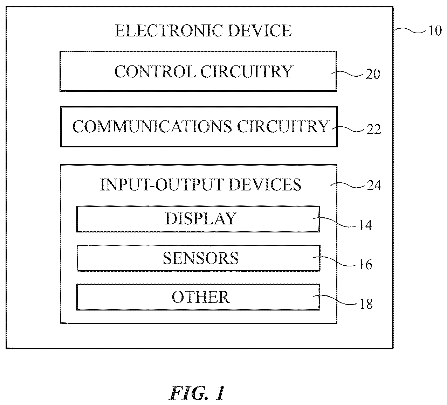

A schematic diagram of an illustrative electronic device having a display is shown in FIG. 1. Device 10 may be a cellular telephone, tablet computer, laptop computer, wristwatch device or other wearable device, a television, a stand-alone computer display or other monitor, a computer display with an embedded computer (e.g., a desktop computer), a system embedded in a vehicle, kiosk, or other embedded electronic device, a media player, or other electronic equipment. Configurations in which device 10 is a cellular telephone, tablet computer, or other portable electronic device may sometimes be described herein as an example. This is illustrative. Device 10 may, in general, be any suitable electronic device with a display.

Device 10 may include control circuitry 20. Control circuitry 20 may include storage and processing circuitry for supporting the operation of device 10. The storage and processing circuitry may include storage such as nonvolatile memory (e.g., flash memory or other electrically-programmable-read-only memory configured to form a solid state drive), volatile memory (e.g., static or dynamic random-access-memory), etc. Processing circuitry in control circuitry 20 may be used to gather input from sensors and other input devices and may be used to control output devices. The processing circuitry may be based on one or more microprocessors, microcontrollers, digital signal processors, baseband processors and other wireless communications circuits, power management units, audio chips, application specific integrated circuits, etc. During operation, control circuitry 20 may use a display and other output devices in providing a user with visual output and other output.

To support communications between device 10 and external equipment, control circuitry 20 may communicate using communications circuitry 22. Circuitry 22 may include antennas, radio-frequency transceiver circuitry (wireless transceiver circuitry), and other wireless communications circuitry and/or wired communications circuitry. Circuitry 22, which may sometimes be referred to as control circuitry and/or control and communications circuitry, may support bidirectional wireless communications between device 10 and external equipment over a wireless link (e.g., circuitry 22 may include radio-frequency transceiver circuitry such as wireless local area network transceiver circuitry configured to support communications over a wireless local area network link, near-field communications transceiver circuitry configured to support communications over a near-field communications link, cellular telephone transceiver circuitry configured to support communications over a cellular telephone link, or transceiver circuitry configured to support communications over any other suitable wired or wireless communications link). Wireless communications may, for example, be supported over a Bluetooth^{®} link, a WiFi^{®} link, a wireless link operating at a frequency between 6 GHz and 300 GHz, a 60 GHz link, or other millimeter wave link, cellular telephone link, wireless local area network link, personal area network communications link, or other wireless communications link. Device 10 may, if desired, include power circuits for transmitting and/or receiving wired and/or wireless power and may include batteries or other energy storage devices. For example, device 10 may include a coil and rectifier to receive wireless power that is provided to circuitry in device 10.

Device 10 may include input-output devices such as devices 24. Input-output devices 24 may be used in gathering user input, in gathering information on the environment surrounding the user, and/or in providing a user with output. Devices 24 may include one or more displays such as display 14. Display 14 may be an organic light-emitting diode display, a liquid crystal display, an electrophoretic display, an electrowetting display, a plasma display, a microelectromechanical systems display, a display having a pixel array formed from crystalline semiconductor light-emitting diode dies (sometimes referred to as microLEDs), and/or other display. Configurations in which display 14 is an organic light-emitting diode display or microLED display are sometimes described herein as an example.

Display 14 may have an array of pixels configured to display images for a user. The pixels may be formed as part of a display panel that is bendable. This allows device 10 to be folded and unfolded about a bend axis. For example, a flexible (bendable) display in device 10 may be folded so that device 10 may be placed in a compact shape for storage and may be unfolded when it is desired to view images on the display.

Sensors 16 in input-output devices 24 may include force sensors (e.g., strain gauges, capacitive force sensors, resistive force sensors, etc.), audio sensors such as microphones, touch and/or proximity sensors such as capacitive sensors (e.g., a two-dimensional capacitive touch sensor integrated into display 14, a two-dimensional capacitive touch sensor overlapping display 14, and/or a touch sensor that forms a button, trackpad, or other input device not associated with a display), and other sensors. If desired, sensors 16 may include optical sensors such as optical sensors that emit and detect light, ultrasonic sensors, optical touch sensors, optical proximity sensors, and/or other touch sensors and/or proximity sensors, monochromatic and color ambient light sensors, image sensors, fingerprint sensors, temperature sensors, sensors for measuring three-dimensional non-contact gestures ("air gestures"), pressure sensors, sensors for detecting position, orientation, and/or motion (e.g., accelerometers, magnetic sensors such as compass sensors, gyroscopes, and/or inertial measurement units that contain some or all of these sensors), health sensors, radio-frequency sensors, depth sensors (e.g., structured light sensors and/or depth sensors based on stereo imaging devices that capture three-dimensional images), optical sensors such as self-mixing sensors and light detection and ranging (lidar) sensors that gather time-of-flight measurements, humidity sensors, moisture sensors, gaze tracking sensors, and/or other sensors. In some arrangements, device 10 may use sensors 16 and/or other input-output devices to gather user input. For example, buttons may be used to gather button press input, touch sensors overlapping displays can be used for gathering user touch screen input, touch pads may be used in gathering touch input, microphones may be used for gathering audio input, accelerometers may be used in monitoring when a finger contacts an input surface and may therefore be used to gather finger press input, etc.

If desired, electronic device 10 may include additional components (see, e.g., other devices 18 in input-output devices 24). The additional components may include haptic output devices, audio output devices such as speakers, light-emitting diodes for status indicators, light sources such as light-emitting diodes that illuminate portions of a housing and/or display structure, other optical output devices, and/or other circuitry for gathering input and/or providing output. Device 10 may also include a battery or other energy storage device, connector ports for supporting wired communication with ancillary equipment and for receiving wired power, and other circuitry.

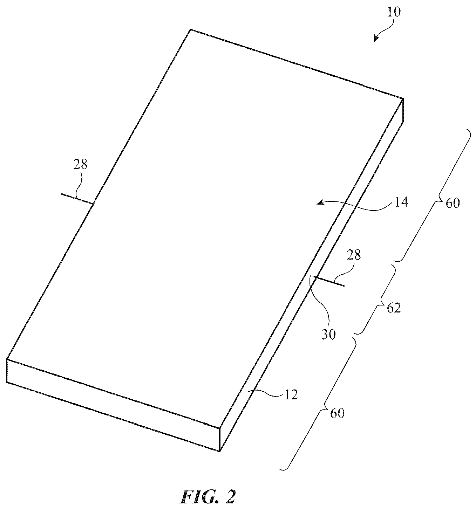

FIG. 2 is a perspective view of electronic device 10 in an illustrative configuration in which device 10 is a portable electronic device such as a cellular telephone or tablet computer. As shown in FIG. 2, device 10 may have a display such as display 14. Display 14 may cover some or all of the front face of device 10. Touch sensor circuitry such as two-dimensional capacitive touch sensor circuitry may be incorporated into display 14.

Display 14 may be mounted in housing 12. Housing 12 may form front and rear housing walls, sidewall structures, and/or internal supporting structures (e.g., a frame, an optional midplate member, etc.) for device 10. Glass structures, transparent polymer structures, and/or other transparent structures that cover display 14 and other portions of device 10 may provide structural support for device 10 and may sometimes be referred to as housing structures. For example, a transparent housing portion such as a glass or polymer housing structure that covers and protects a pixel array in display 14 may serve as a display cover layer for the pixel array while also serving as a housing wall on the front face of device 10. In configurations in which a display cover layer is formed from glass, the display cover layer may sometimes be referred to as a display cover glass or display cover glass layer. The portions of housing 12 on the sidewalls and rear wall of device 10 may be formed from glass or other transparent structures and/or opaque structures. Sidewalls and rear wall structures may be formed as extensions to the front portion of housing 12 (e.g., as integral portions of the display cover layer) and/or may include separate housing wall structures.

Device 10 may be a foldable electronic device that folds along one or more bend axes such as bend axis 28. In the example of FIG. 2, device 10 includes first and second portions 60 joined by bendable portion 62. Portions 60 of device 10 (e.g., portions 60 of display 14 and housing 12, sometimes referred to as the non-bending regions of device 10) may rotate relative to one another about axis 28. As one portion 60 rotates relative to another portion 60 (e.g., during folding and unfolding of device 10), bendable portion 62 of display 14 may bend and flex (e.g., while portions 60 remain flat).

Housing 12 may have flexible structures (e.g., bendable housing wall structures) and/or hinge structures such as hinge 30. Hinge 30 may have a hinge axis aligned with or offset relative to display bend axis 28, depending on the type of hinge used. Bend axis 28 may, for example, be the bend axis around which display 14 bends, whereas hinge 30 may bend about a hinge bend axis. In some arrangements such as teardrop hinge arrangements, the hinge bend axis of hinge 30 may be aligned with display bend axis 28 of display 14. In other arrangements such as constant length hinge arrangements (e.g., a roller hinge), the hinge bend axis may be offset from display bend axis 28. Device 10 may include one or more translation modules that facilitate translation of display 14 relative to housing 12 that may be needed to accommodate the offset between display bend axis 28 and the hinge bend axis.

Hinge 30 and/or flexible housing structures that overlap bend axis 28 may allow housing 12 to bend about the hinge bend axis. For example, portion 60 of housing 12 may be located on one side of hinge 30 and another portion 60 of housing 12 may be located on the opposing side of bend hinge 30. Portions 60 of housing 12 may be configured to rotate relative to one another about hinge 30. Hinge 30 may be a roller hinge including one or more rollers each having a longitudinal axis that extends parallel to bend axis 28. This is merely illustrative. If desired, hinge 30 may include other types of hinge structures.

As housing 12 is bent about hinge 30, the flexibility of display 14 allows display 14 to bend about axis 28. In an illustrative configuration, housing 12 and display 14 may bend by 180°. This allows display 14 to be folded back on itself (e.g., such that first and second portions 60 of display 14 face each other). The ability to place device 10 in a folded configuration in this way may help make device 10 compact so that device 10 can be stored efficiently. When it is desired to view images on display 14, device 10 may be unfolded about axis 28 to place device 10 in the unfolded (e.g., flat) configuration of FIG. 2. This allows display 14 to lie flat and allows a user to view flat images on display 14. The ability to fold display 14 onto itself allows device 10 to exhibit an inwardly folding behavior. Display 14 may be sufficiently flexible to allow device 10 to be folded outwardly and/or inwardly, if desired.

Device 10 of FIG. 2 has a rectangular outline (rectangular periphery) with four corners. As shown in FIG. 2, a first pair of parallel edges (e.g., the left and right edges of device 10 in the example of FIG. 2) may be longer than a second pair of parallel edges (e.g., the upper and lower edges of device 10 of FIG. 2) that are oriented at right angles to the first pair of parallel edges. In this type of configuration, housing 12 is elongated along a longitudinal axis that is perpendicular to bend axis 28. Housing 12 may have other shapes, if desired (e.g., shapes in which housing 12 has a longitudinal axis that extends parallel to bend axis 28). With an arrangement of the type shown in FIG. 2, the length of device 10 along its longitudinal axis may be reduced by folding device 10 about axis 28.

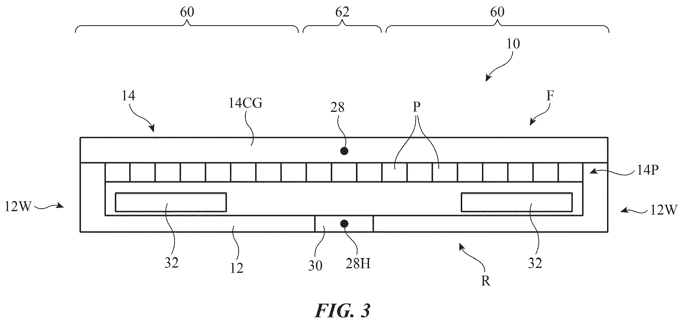

FIG. 3 is a cross-sectional side view of an illustrative foldable electronic device. Device 10 of FIG. 3 may bend about bend axis 28. Bend axis 28 may be aligned with display cover layer 14CG or other structures in device 10. For example, bend axis 28 may pass through a portion of display cover layer 14CG or may be located above or below layer 14CG.

Hinge 30 may bend about one or more hinge axes such as hinge bend axis 28H (sometimes referred to as a hinge axis, a rotational axis, etc.). In arrangements where hinge 30 is a teardrop hinge, hinge bend axis 28H of hinge 30 may be aligned with display bend axis 28 of display 14. In arrangements where hinge 30 is a constant length hinge such as a roller hinge, hinge bend axis 28H may be offset from display bend axis 28. Device 10 may include one or more translation modules that help slide display 14 relative to housing 12 during opening and closing of device 10 to accommodate the offset between display bend axis 28 and hinge bend axis 28H.

As shown in FIG. 3, display 14 includes an array of pixels P forming display panel 14P under an inwardly facing surface of display cover layer 14CG. Display panel 14P may be, for example, a flexible organic light-emitting diode display or a microLED display in which light-emitting pixels are formed on a flexible substrate layer (e.g., a flexible layer of polyimide or a sheet of other flexible polymer). Flexible support layer(s) for display 14 may also be formed from flexible glass, flexible metal, and/or other flexible structures.

Display cover layer 14CG may be formed from polymer, glass, crystalline materials such as sapphire, other materials, and/or combinations of these materials. To enhance flexibility, a portion of layer 14CG that overlaps bend axis 28 may be locally thinned (e.g., this portion may be thinned relative to portions of layer 14CG that do not overlap bend axis 28). The thickness of layer 14CG (e.g., the non-thinned portions of layer 14CG) may be 50-200 microns, 70-150 microns, 100-200 microns, 100-600 microns, at least 100 microns, at least 200 microns, less than 600 microns, less than 400 microns, less than 250 microns, less than 150 microns, less than 100 microns, at least 50 microns, or other suitable thickness.

In the example of FIG. 3, housing 12 has portions that form a rear housing wall on rear face R of device 10 and has portions forming sidewalls 12W of device 10. The rear housing wall of housing 12 may form a support layer for components in device 10. Housing 12 may also have one or more interior supporting layers (e.g., frame structures such as an optional midplate, etc.). These interior supporting layers and the rear housing wall may have first and second portions that are coupled to opposing sides of hinge 30 or may be sufficiently flexible to bend around bend axis 28.

Electrical components 32 may be mounted in the interior of device 10 (e.g., between display 14 and the rear of housing 12. Components 32 may include circuitry of the type shown in FIG. 1 (e.g., control circuitry 20, communications circuitry 22, input-output devices 24, batteries, etc.). Display 14 may be mounted on front face F of device 10. When device 10 is folded about axis 28, display cover layer 14CG, display panel 14P, and the other structures of device 10 that overlap bend axis 28 may flex and bend to accommodate folding.

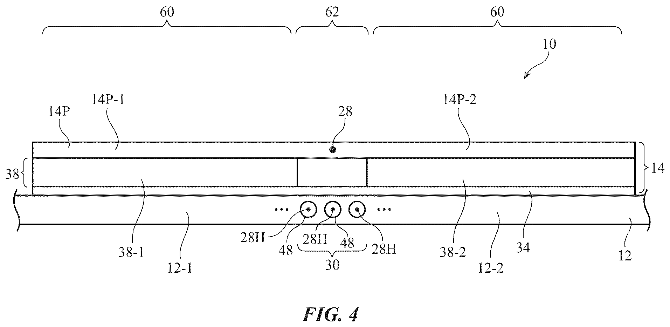

FIG. 4 is a side view of device 10 in a flat state (sometimes referred to as an open state or unfolded state). As shown in FIG. 4, device 10 may include foldable display 14 mounted to a housing such as foldable housing 12. Housing 12 may have first housing portion 12-1 and second housing portion 12-2. Hinge 30 may be located between housing portions 12-1 and 12-2 and may allow housing portions 12-1 and 12-2 to rotate relative to one another about one or more hinge bend axes 28H. Housing portions 12-1 and 12-2 may form rear housing walls on the rear face R of device 10 (FIG. 3).

Display 14 may include a display panel such as display panel 14P mounted to a display plate such as display plate 38 (sometimes referred to as a support structure, a midplate, a backplate, etc.). Display plate 38 may include first portion 38-1 that supports a first portion 14P-1 of display panel 14P on one side of bend axis 28 and a second portion 38-2 that supports a second portion 14P-2 of display panel 14P on an opposing side of bend axis 28. Display plates 38-1 and 38-2 may rotate relative to one another about bend axis 28 as device 10 is opened and closed. Display plate 38-1 may overlap portion 12-1 of housing 12 and display plate 38-2 may overlap portion 12-2 of housing 12.

Display panel portion 14P-1 may be fixed relative to display plate 38-1, while display plate 38-1 may be movable relative to housing portion 12-1 (e.g., display plate 38-1 may be permitted to shear and slide relative to housing 12-1 during opening and closing of device 10). Similarly, display panel portion 14P-2 may be fixed relative to display plate 38-2, while display plate 38-2 may be movable relative to housing portion 12-2 (e.g., display plate 38-2 may be permitted to shear and slide relative to housing 12-2 during opening and closing of device 10). If desired, an optional shearing layer 34 may be interposed between housing 12 and display plate 38 to allow display 14 to slide relative to housing 12. Layer 34 may include one or more flexible polymers, coatings of lubricant, and/or other suitable slippery materials (e.g., polytetrafluoroethylene).

The ability of display 14 to move (e.g., slide) relative to housing 12 may permit housing 12 to use different types of hinge structures such as a roller hinge. In particular, hinge 30 may be a roller hinge having one or more parallel rollers such as rollers 48. Rollers 48 may have longitudinal axes that extend parallel to bend axis 28. Hinges of this type (sometimes referred to as constant-length hinges) may span a distance between housing portions 12-1 and 12-2 that remains constant as device 10 is folded and unfolded. This is merely illustrative, however. If desired, hinge 30 may be any other suitable type of hinge (e.g., a four-bar linkage, a teardrop hinge, a flexible housing member, etc.). In some hinge arrangements (such as a teardrop hinge), translation of display 14 relative to housing 12 may be used to absorb tolerances (e.g., during manufacturing or during operation of device 10 by a user over time). Arrangements in which display 14 slides relative to housing 12 during opening and closing of device 10 are sometimes described herein as an illustrative example.

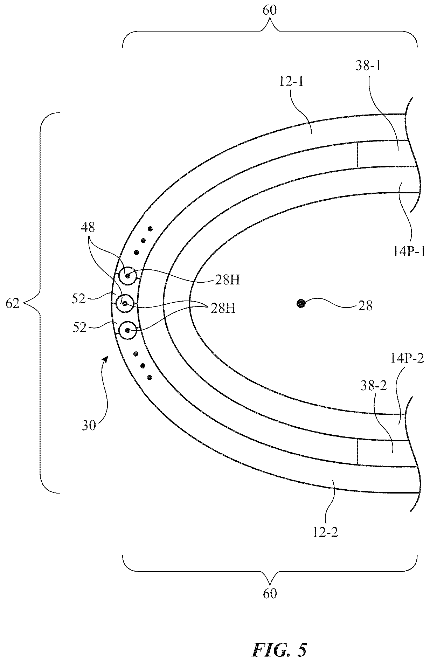

Hinge 30 (sometimes referred to as a hinge assembly) may have a multilink design that allows hinge 30 to bend about multiple hinge axes 28H. As shown in FIG. 5, for example, hinge 30 may have multiple interconnected portions such as links 52 coupled between rollers 48. Links 52 may have an hourglass shape with first and second recesses for receiving respective first and second rollers 48. Links 52 may be coupled to each other for rotational motion and may extend in a linked series between housing portions 12-1 and 12-2. As device 10 moves from the flat state of FIG. 4 to the folded (e.g., closed) state of FIG. 5, a first pair of links 52 of hinge 30 may bend about a first hinge axis 28H, a second pair of links 52 of hinge 30 may bend about a second hinge axis 28H, a third pair of links of hinge 30 may bend about a third hinge axis 28H, etc. Hinge 30 may bend about two, three, four, five, six, or more than six hinge axes 28H. Arrangements in which hinge 30 has six parallel axes 28H of rotation are sometimes described herein as an illustrative example.

Each pair of adjacent hinge links 52 may be restricted in its amount of overall rotation. For example, links 52 may be configured so that no two adjacent links 52 are allowed to rotate more than a maximum rotation angle (e.g., a maximum rotation angle that is less than 180°, less than 90°, less than 45°, less than 25°, 5-50°, or within any other suitable range. With this arrangement, links 52 collectively allow hinge 30 to rotate by a desired amount (e.g., 180°) without creating an excessively small bend radius for display 14 about bend axis 28. The maximum rotation angle may be the same for all pairs of adjacent links 52 or different pairs of adjacent links 52 may have different maximum rotation angles. As an example, the maximum rotation angle may be 30° for the link pairs that are adjacent to housing 12, whereas the maximum rotation angle may be 60° for the link pairs in the middle of hinge 30. Arrangements where each link rotates by the same maximum rotation angle with respect to its neighboring links and/or in which the middle links 52 in hinge 30 have maximum rotation angles than the links 52 immediately adjacent to housing 12 may also be used, if desired.

To maintain satisfactory friction between rotating parts of device 10, hinge 30 may be provided with friction clutch structures. As an example, in addition to rollers 48 and links 52, hinge 30 may be provided with interdigitated sets of fingers that are pressed together to create rotational friction when rotating with respect to each other. These friction-producing structures, which may sometimes be referred to as leaves, friction clutch structures, a friction clutch, hinge friction structures, rotational friction structures, etc., may be integrated into links 52, may be attached to links 52 so that the friction-producing structures produce rotational friction for the attached links 52, and/or may otherwise be coupled between portions of housing 12 that rotate with respect to each other. The friction produced by the friction clutch structures allows a first portion of housing 12 to be maintained in a desired rotational orientation with respect to a second portion of housing 12 (e.g., housing halves 12-1 and 12-2 may be placed perpendicular or nearly perpendicular to each other, may be closed onto each other, may be placed in an open planar configuration, and/or may otherwise be positioned as desired by rotating these portions with respect to each other about bend axes 28H of hinge 30).

Hinge 30 may include friction leaves with intermeshed gears (e.g., teeth) for driving synchronous motion of housing portions 12-1 and 12-2, may include friction leaves with protruding elements that form a hard stop (e.g., a travel limit) in the open position and/or the closed position, and/or may include friction leaves with overlapping slots and mating pins that provide both synchronous motion of housing portions 12-1 and 12-2 as well as hard stops in the open and closed positions.

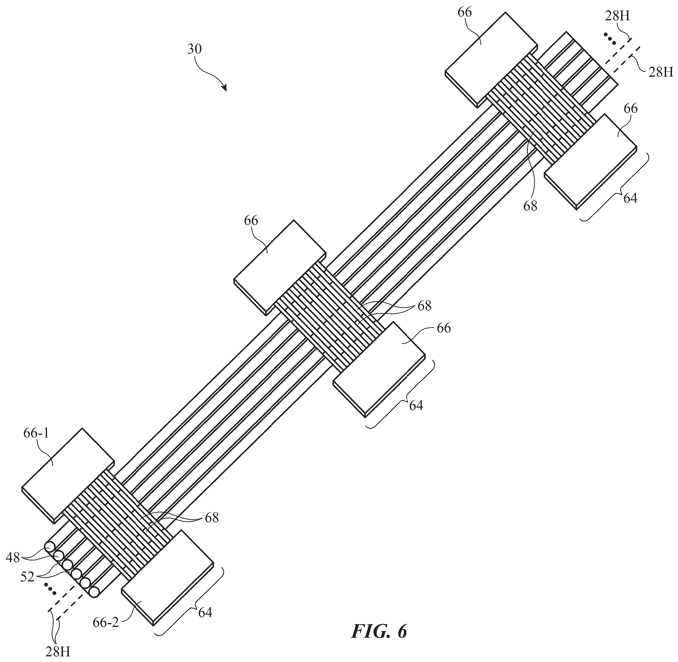

FIG. 6 is a perspective view of an illustrative hinge 30. Hinge 30 (sometimes referred to as a hinge assembly) may include rollers 48 (e.g., elongated cylinders) coupled by links 52. Links 52 may be hourglass-shaped structures with recesses for receiving respective rollers 48. Hinge rollers 48 may serve as a flexible outer housing layer that bridges the gap between housing portions 12-1 and 12-2 of housing 12. Hinge rollers 48 may be exposed on an outer surface (e.g., an outer spine) of device 10, or hinge rollers 48 may be concealed from view by a separate outer housing layer over hinge 30. Each link 52 may be configured to rotate relative to an adjacent link 52 about a respective hinge axis 28H that is aligned with the longitudinal axis of a given roller 48.

Hinge 30 may include one or more hinge modules 64 coupled to rollers 48. Hinge modules 64 may overlap rollers 48 and may be interposed between rollers 48 and display 14. While rollers 48 may permit rotation of housing portions 12-1 and 12-2 about hinge axes 28H, synchronous motion of housing portion 12-1 and housing portion 12-2 may be driven by hinge modules 64. In the example of FIG. 6, hinge 30 includes three hinge modules 64, with two hinge modules 64 located at the outer edges of hinge 30 and one hinge module 64 located at the center of hinge 30. If desired, hinge 30 may include greater than three or fewer than three hinge modules 64.

Each hinge module 64 may include first and second plates such as hinge plates 66 that attach to a respective one of housing portions 12-1 and 12-2. For example, hinge plate 66-1 may be fixed to housing portion 12-1 on one side of hinge 30, and hinge plate 66-2 may be fixed to housing portion 12-2 on an opposing side of hinge 30. Screws or other attachment structures may be used to attach each hinge plate 66 to a respective one of housing portions 12-1 and 12-2.

A series of interdigitated hinge leaves such as hinge leaves 68 may extend between plates 66. Each leaf 68 (sometimes referred to as a hinge finger, a finger, a friction element, a friction leaf, a friction clutch member, etc.) may be formed from a thin metal plate with one or more openings for receiving shafts and/or pins, gears that form teeth for driving synchronous motion, protrusions for forming hard stops in the open and closed positions, and/or other features. Leaves 68 may be pressed together to create rotational friction when rotating with respect to each other. The friction produced by leaves 68 allows housing portion 12-1 to be maintained in a desired rotational orientation with respect to housing portion 12-2 (e.g., housing portions 12-1 and 12-2 may be placed perpendicular or nearly perpendicular to each other, may be closed onto each other, may be placed in an open planar configuration, and/or may otherwise be positioned as desired by rotating these portions with respect to each other about bend axes 28H of hinge 30).

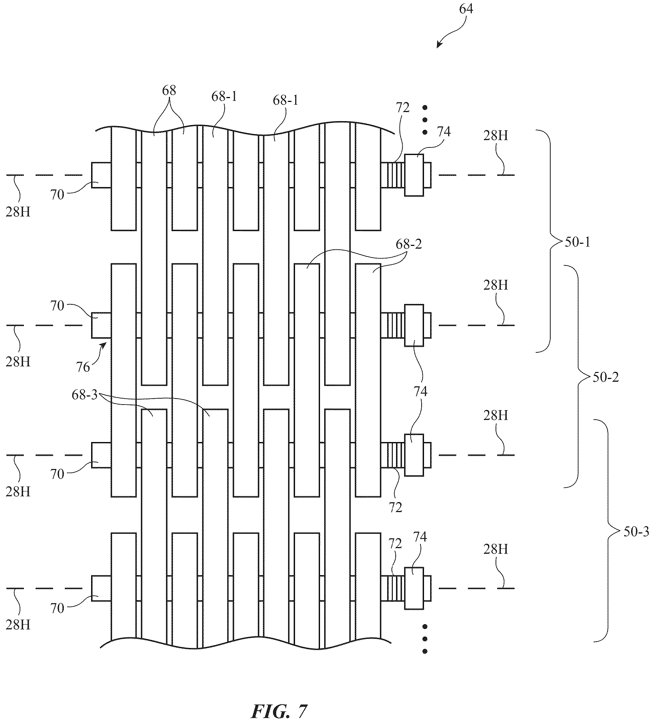

FIG. 7 is a top view of an illustrative hinge module 64 formed from interdigitated leaves 68. In the example of FIG. 7, hinge module 64 has a first set 50-1 of leaves 68-1 and a second set 50-2 of leaves 68-2. Fingers 68-1 in the first set 50-1 are interdigitated with fingers 68-2 in the second set 50-2. A shaft such as shaft 70 may pass through a respective opening 76 in each leaf 68. A respective one of hinge axes 28H may be aligned with the longitudinal axis of shaft 70 (which is also aligned with the longitudinal axis of a given roller 48). Fingers 68-1 of first set 50-1 and fingers 68-2 of second set 50-2 rotate relative to each other about hinge axis 28H. Some leaves 68 may include first and second openings 76 for respectively receiving first and second shafts 70. For example, leaves 68-2 may include a first opening 76 for a first shaft 70 that links leaves 68-2 with leaves 68-1 of set 50-1 and may include a second opening 76 for a second shaft 70 that links leaves 68-2 with leaves 68-3 of set 50-3.

A spring such as spring 72 (e.g., disc-shaped springs, a stack of washers that form a spring, etc.) may be inserted onto shaft 70 and may be configured to press fingers 68 towards each other along shaft 70. Fingers 68 may be relatively thin (e.g., fingers 68 may have a relatively small dimension along the axis of shaft 70) and may have relatively larger surface areas where fingers 68 contact each other (e.g., fingers 68 may be thin plates). This allows satisfactory friction to be created without requiring an overly bulky clutch. A nut such as nut 74 that is threaded onto shaft 70 may be used to adjust the amount by which spring 72 presses fingers 68 together along shaft 70 to impart a desired amount of friction (e.g., sufficient friction to hold first and second housing portions 12-1 and 12-2 at a desired angle relative to each to each other when the first portion is resting on a surface).

The structures of FIG. 7 may be repeated depending on the number of rotational axes in hinge 30. For example, if there are six hinge axes 28H in hinge 30, there may be six shafts 70 that each pass through a respective pair of sets of interdigitated leaves 68.

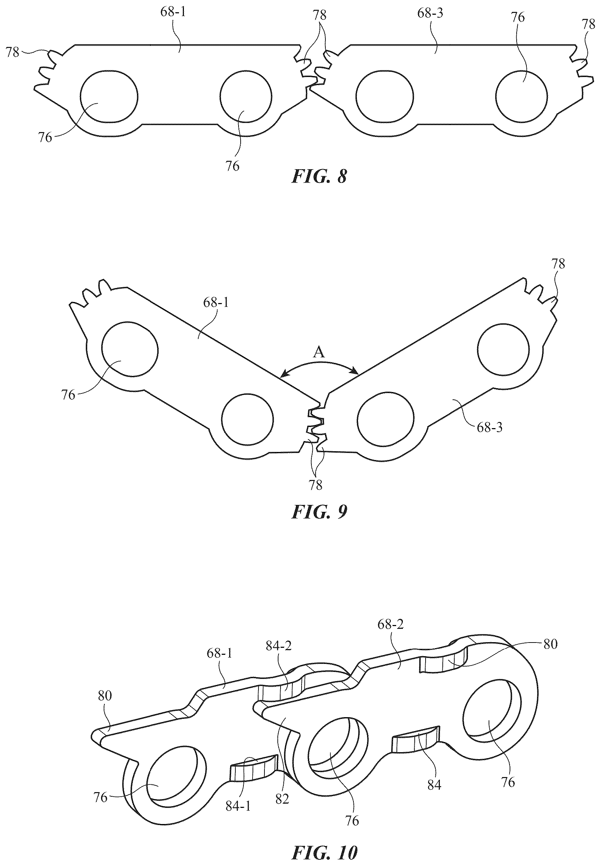

To help ensure that leaves 68 rotate evenly throughout hinge 30, device 10 may have intermeshed gears that extend between rotating portions of housing 12 (e.g., in parallel with hinge 30). The gears and/or other rotation synchronization structures may help ensure that movement of housing portion 12-1 will produce equal and opposite movement of opposing housing portion 12-2. An illustrative rotation synchronization mechanism with gears of the type that may be used for rotational (angular movement) synchronization in hinge 30 are shown in FIGS. 8 and 9.

As shown in FIG. 8, leaf 68-1 and leaf 68-3 may include mating gears such as gears 78. During operation, housing portions 12-1 and 12-2 can rotate with respect to each other about axes 28H. Angular movement synchronization gears 78, which are formed from teeth on the opposing edges of leaves 68, are coupled in series between housing portions 12-1 and 12-2. This arrangement causes rotation of one side of device 10 to cause equal and opposite rotation of the other side of device 10.

As shown in FIG. 9, clockwise rotation of gear 78 of leaf 68-1 causes gear 78 of leaf 68-3 to rotate counterclockwise. A series of gears 78 coupled in this way between housing portions 12-1 and 12-2 may be used to drive synchronous motion of housing portions 12-1 and 12-2. If desired, each adjacent pair of gears 78 may provide synchronous motion across a given range A of angles (e.g., where angle A is equal to 30.5°, equal to 30°, between 30° and 35°, between 25° and 40°, between 15° and 60°, less than 35°, greater than 35°, etc.).

FIG. 10 shows an illustrative leaf 68 that may be used to provide a hard stop in the open position and/or the closed position. As shown in FIG. 10, leaf 68-1 and leaf 68-2 may include hard stop structures 80. Hard stop structures 80 may include protrusions 82 and surfaces 84. Protrusions 82 may travel back and forth between hard stop surfaces 84 as device 10 is opened and closed. When protrusion 82 reaches hard stop surface 84-2, device 10 may be prevented from being opened further. When protrusion 82 reaches hard stop surface 84-1, device 10 may be prevented from being closed further.

In some arrangements, hinge module 64 of FIGS. 6 and 7 may include a first group of leaves 68 having the structure of FIGS. 8 and 9 and a second group of leaves 68 having the structure of FIG. 10. The first group of leaves 68 may be used to drive synchronous motion of housing portions 12-1 and 12-2, whereas the second group of leaves 68 may be used to prevent overtravel in the open and closed directions. For example, each set 50 of leaves 68 may include some leaves 68 with gears 78 of FIGS. 8 and 9 and some leaves 68 with hard stop structures 80 of FIG. 10.

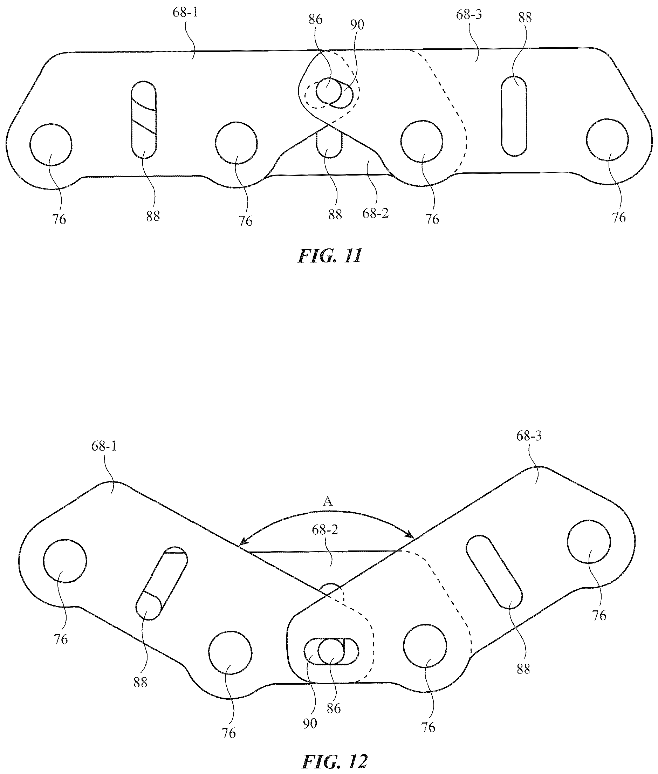

In some arrangements, the same set of leaves 68 may be configured to drive synchronous motion of housing portions 12-1 and 12-2 and to prevent overtravel of housing portions 12-1 and 12-2 in the open and/or closed positions. FIGS. 11 and 12 show illustrative leaves 68 that may be used to both drive synchronous motion as well as provide a hard stop in the open and closed positions.

As shown in FIG. 11, leaf 68-1 and leaf 68-3 may be mirror images of each other. Each leaf 68 may include a pair of openings 76 for receiving a respective pair of shafts 70, as discussed in connection with FIG. 7. Additionally, leaves 68-1 and 68-3 may each include a smaller opening 90 (sometimes referred to as a pin opening or mutual pin opening) for receiving a pin such as pin 86 (sometimes referred to as a mutual pin or a timing pin). Leaf 68-2 may overlap leaves 68-1 and 68-3 and may include a vertical slot 88 that overlaps openings 90 of leaves 68-1 and 68-3. Pin 86 may be received within opening 90 of leaf 68-1, opening 90 of leaf 68-3, and slot 88 of leaf 68-2.

As leaf 68-1 rotates relative to leaf 68-3 during opening and closing of device 10, slot 88 of leaf 68-2 may ensure that pin 86 stays an equal distance from the two adjacent hinge axes 28H on either side of pin 86. Each hinge axis 28H may each pass through a respective one of shaft openings 76 where shaft 70 is received. This provides synchronous motion of housing portion 12-1 relative to housing portion 12-2 over angle range A of FIG. 12. Angle A may be equal to 30.5°, equal to 30°, between 30° and 35°, between 25° and 40°, between 15° and 60°, less than 35°, greater than 35°, or any other suitable angle.

Additionally, the top and bottom edges of vertical slot 88 provide hard stop surfaces that limit travel in both the open direction and the closed direction. When pin 86 reaches the top of slot 88, as shown in the flat state of FIG. 11, pin 86 may be prevented from traveling further in that direction and housing portions 12-1 and 12-2 may be prevented from opening further. When pin 86 reaches the bottom of slot 88, as shown in the folded state of FIG. 12, pin 86 may be prevented from traveling further in that direction and housing portions 12-1 and 12-2 may be prevented from closing further.

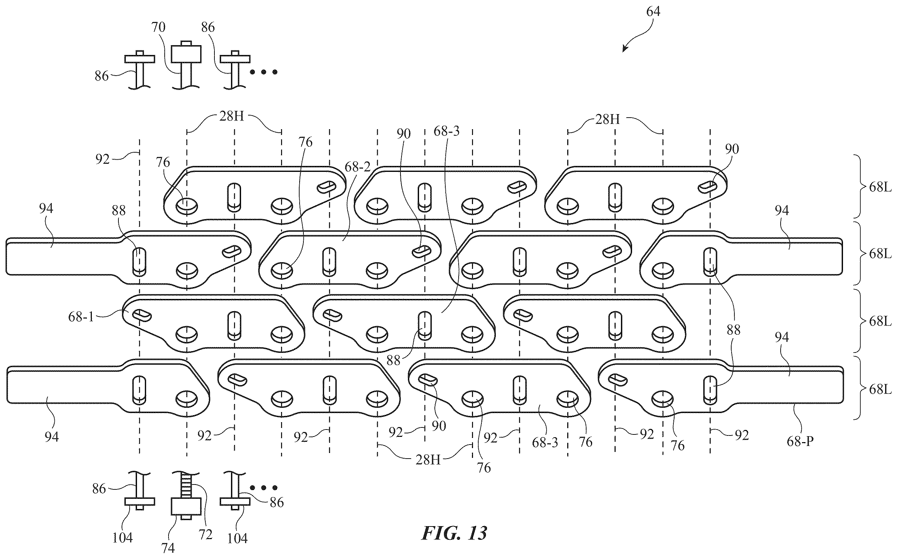

FIG. 13 is an exploded perspective view of an illustrative hinge module 64 that uses leaves 68 of the type shown in FIGS. 11 and 12. In the example of FIG. 13, hinge module 64 may include four layers 68L of leaves 68. This is merely illustrative. If desired, hinge module 64 may include more than four layers 68L of leaves 68. Leaves 68 at the outer ends of hinge module 64 may include protruding portions 68P for attaching to hinge plates 66 (FIG. 6) and/or for attaching directly to housing 12.

As shown in FIG. 13, leaves 68 include openings 90 and vertical slots 88 for receiving pins 86. Each pin 86 may be inserted through openings 90 and slots 88 along a respective mutual pin axis 92 of FIG. 13. Each shaft 70 may be inserted through shaft openings 76 along a respective hinge axis 28H of FIG. 13. Each hinge axis 28H may be located between a pair of pin axes 92. In the example of FIG. 13, hinge module 64 includes six shafts 70 that permit rotation of leaves 68 about six parallel hinge axes 28H. Seven pins 86 oriented along seven parallel pin axes 92 are used to impose synchronous motion of housing portions 12-1 and 12-2, while the upper and lower surfaces of vertical slot 88 form hard stops for preventing overtravel in the open and closed directions.

One of the benefits of using pins 86 is that the torque of each hinge axis 28H can be tuned individually to ensure even torque, even wear, and consistent performance. For example, before pins 86 are installed in hinge module 64, nuts 74 on respective shafts 70 may be tightened or loosened to achieve the desired amount of torque through axial friction between leaves 68 along each shaft 70. Once the desired amount of torque is achieved on each shaft 70, pins 86 may be installed along pin axes 92. A nut 104 or other fastener may be attached to the end of each pin 86 to fix pin 86 within openings 90 and slots 88.

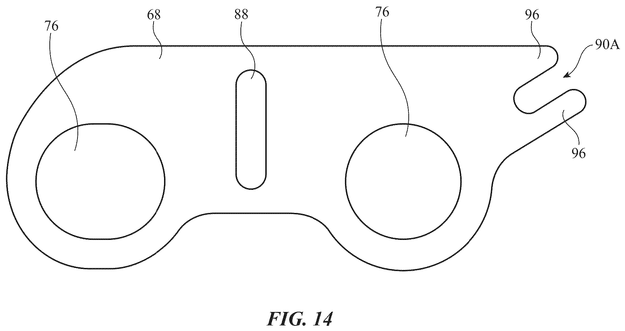

FIG. 14 shows another illustrative configuration for leaf 68 that may be used with a mutual pin gear setup of the type described in connection with FIGS. 11, 12, and 13. As shown in FIG. 14, opening 90 may include one or more cantilevered arms 96 (e.g., teeth that form a gear). Pin 86 may be received between the two cantilevered arms 96. The open arm arrangement of FIG. 14 may provide less strength than the closed opening 90 of FIGS. 11, 12, and 13, but additional strength can be provided by increasing the thickness of arms 96 (if needed).

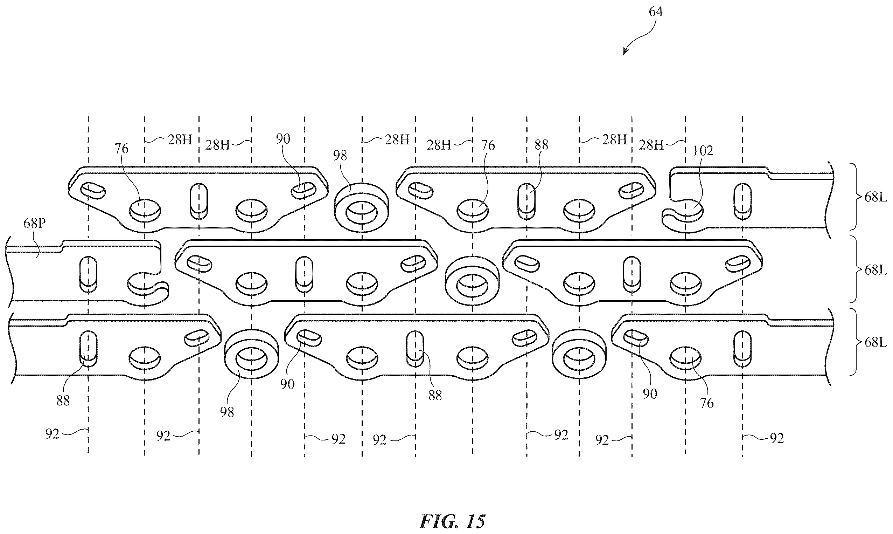

FIG. 15 shows another illustrative arrangement for hinge module 64 that includes a mutual pin gear of the type described in connection with FIGS. 11, 12, and 13. In the example of FIG. 15, leaves 68 each include first and second openings 76 for receiving respective shafts 70, first and second openings 90 for receiving respective pins 86, and slot 88 for receiving an additional pin 86. Washers 98 that receive shafts 70 may be used as spacer elements between certain pairs of leaves 68. This type of "double header" leaf 68 (e.g., in which both ends of leaf 68 include a respective opening 90 for receiving pin 86, as opposed to just one end in the example of FIG. 13) may reduce the minimum number of layers 68L that are needed to achieve synchronous motion functionality and hard stop functionality. For example, three layers 68L of leaves 68 that have openings 90 on both ends may be sufficient to achieve synchronous motion and hard stop functionality. If desired, hinge module 64 may include more than three layers 68L of leaves 68.

As in the example of FIG. 13, hinge module 64 of FIG. 15 includes six shafts 70 that permit rotation of leaves 68 about six parallel hinge axes 28H. Seven pins 86 oriented along seven parallel pin axes 92 are used to impose synchronous motion of housing portions 12-1 and 12-2, with the upper and lower edges of vertical slot 88 forming hard stops for preventing overtravel in the open and closed directions.

If desired, torque on each individual axis 28H may be tuned individually by adjusting nuts 74 on respective shafts 70 before pins 86 are installed. Once the desired amount of torque is achieved on each shaft 70, pins 86 may be installed along pin axes 92.

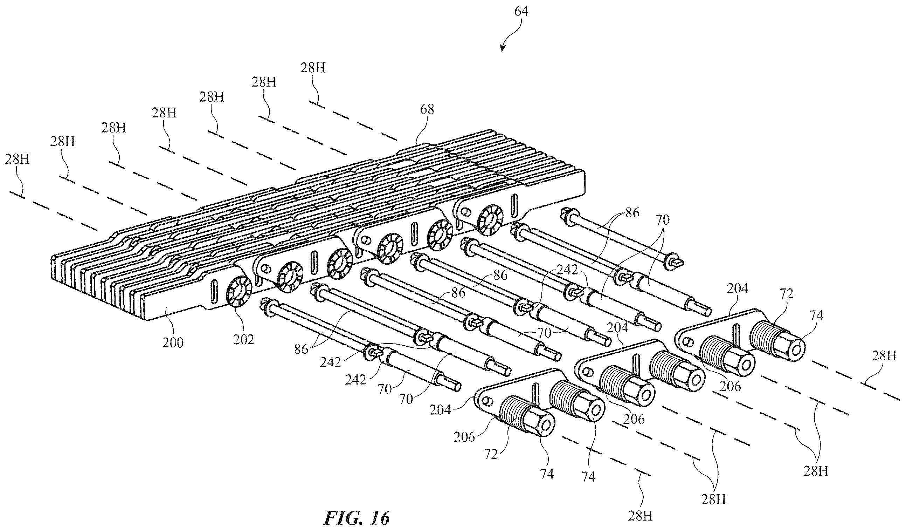

Electronic device 10 may be used in multiple "open" states. In a laptop-type state, device 10 is open in a laptop shape and housing portions 12-1 and 12-2 may be separated by an angle of 90°, 100°, 110°, or some other angle between 45° and 135°. The torque produced by hinge module 64 is sufficiently high that electronic device 10 can remain in this laptop position without snapping closed or snapping open. In a fully open state (e.g., when device 10 is unfolded and flat), housing portions 12-1 and 12-2 are separated by an angle of 180°. If hinge module 64 continues to apply high torque as device 10 moves towards this fully open state, device 10 may tend to spring back on itself, if care is not taken. It may be desirable to reduce the friction in hinge module 64 as electronic device 10 approaches this fully open state. FIG. 16 is an exploded perspective view of an illustrative hinge module 64 that may exhibit a reduction in friction (and therefore torque) as device 10 approaches a fully open, flat state.

As shown in FIG. 16, hinge module 64 may include six shafts 70 that permit rotation of leaves 68 about six parallel hinge axes 28H. Seven pins 86 oriented along seven parallel pin axes are used to impose synchronous motion of housing portions 12-1 and 12-2. This is merely illustrative. If desired, hinge module 64 may have less than six or more than six hinge axes 28H.

Along each hinge axis 28H, spring 72 on shaft 70 may apply a force onto a set of friction leaves 68 that are located on that shaft 70. A set of cams such as cam 200 and cam 204 may be located on shaft 70 (e.g., may have openings that receive shaft 70) between leaves 68 and springs 72. Cams 200 and 204 may be friction reducing cams that are used to adjust the load that is applied by springs 72 on friction leaves 68. Cam 200 may have cam surfaces 202 that engage and disengage with cam surfaces 206 of cam 204 as device opens and closes. Each cam 200 and 204 may bridge two hinge axes 28H (e.g., similar to friction leaves 68).

When device 10 is folded closed (and housing portions 12-1 and 12-2 are separated by an angle of 0°), cam surfaces 202 and 206 may engage and expand apart from each other, which causes cams 200 and 204 to transfer the load from springs 72 onto friction leaves 68. Cam surfaces 202 and 206 may be designed to remain engaged until device 10 approaches a nearly open state (e.g., when housing portions 12-1 and 12-2 are separated by a threshold angle of 160° or more, 170° or more, 150° or more, or some other threshold angle between 110° and 180°), which ensures that sufficient torque is applied by hinge module 64 until device 10 reaches the nearly open state. When device 10 is opened past the given threshold angle, cam surfaces 202 and 206 may disengage, which causes cams 200 and 204 to remove the spring load from friction leaves 68. When friction leaves 68 are no longer loaded by springs 72, the friction in hinge module 64 is reduced and the user may find it easier to move device 10 into the fully open position.

If desired, some or all of shafts 70 may have a shoulder such as shoulder 242. Shoulder 242 may be used to support a load from springs 72 when cams 200 and 204 are disengaged. This may be useful in arrangements where the stroke of cams 200 and 204 is relatively short. Rather than requiring cams 200 and 204 to fully unload springs 72 from friction leaves 68, cams 200 and 204 only partially unload springs 72 until springs 72 are supported by shoulder 242.

If desired, cams 200 and 204 on each hinge axis 28H may disengage (and thereby reduce friction in hinge module 64) at the same threshold angle (e.g., 160° or other suitable angle), or some cams 200 and 204 may disengage at different angles compared to other cams 202 and 204. Friction reduction using cams 200 and 204 can be configured to disengage at any suitable range of angles depending on the desired functionality of device 10.

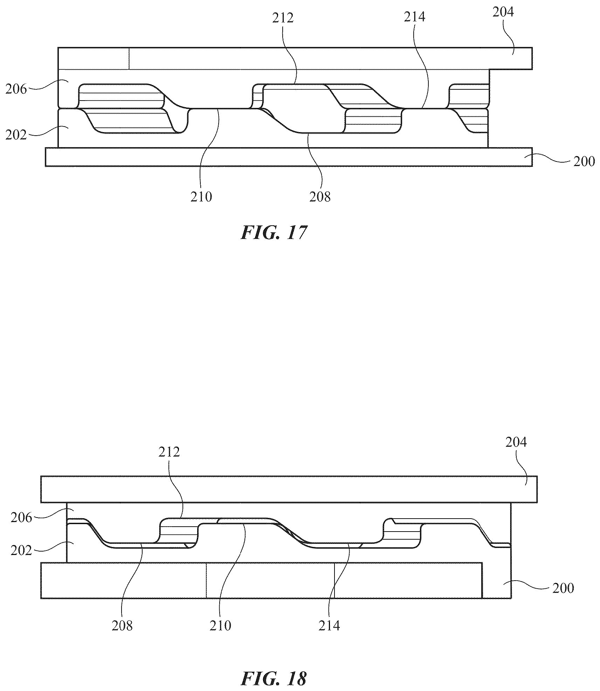

FIGS. 17 and 18 are side views of cams 200 and 204 showing how cam surfaces 202 and 206 may engage and disengage as device 10 moves between folded and flat states.

FIG. 17 shows the positions of cams 200 and 204 when device 10 is in a folded, fully closed state (e.g., when housing portions 12-1 and 12-2 are separated by an angle of 0°). In this closed state, cam surfaces 202 and 206 are engaged. In particular, peaks 210 of cam 200 are aligned with and contacting peaks 214 of cam 204, and the valleys 208 of cam 200 are aligned with the valleys 212 of cam 204. In this position, the load from springs 72 is transferred onto friction leaves 68 and the torque produced by hinge module 64 is relatively high. As device 10 moves from the folded closed position of FIG. 17 to a nearly fully open position, peaks 210 and 214 may remain in contact (and thus cams 200 and 204 may remain engaged) until a threshold angle is reached (e.g., 160° or other suitable threshold angle). At this angle, peaks 214 begin to fall into valleys 208, and peaks 210 begin to fall into valleys 212, until cams 200 and 204 reach the disengaged state of FIG. 18.

In the disengaged state of FIG. 18, peaks 210 of cam 200 are aligned with and received within valleys 212 of cam 204, and the peaks 214 of cam 204 are aligned with and received within valleys 208 of cam 200. In this disengaged position, the load from springs 72 is not transferred onto friction leaves 68 due to a gap that is produced between cam 200 and friction leaves 68. This reduces the torque produced by hinge module 64 when device 10 is in the fully open state compared to the torque produced by hinge module 64 when cams 200 and 204 are engaged and device 10 is in the closed state. If desired, some of the load from springs 72 may be supported by a shoulder on shaft 70 such as shoulder 242 of FIG. 16.

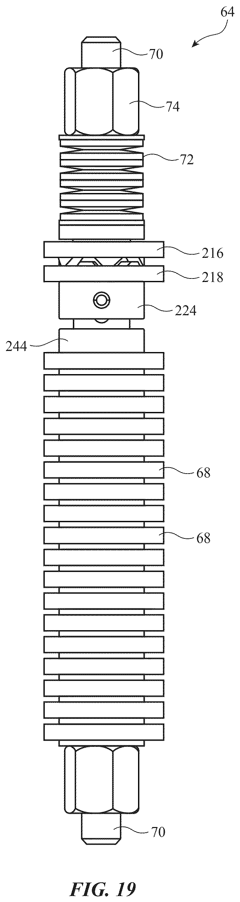

FIG. 19 shows another illustrative example of cams that are used to reduce friction in hinge module 64 as device 10 approaches a fully open state. Cams 216 and 218 may located on shaft 70 and may be interposed between spring 72 and a stack of friction leaves 68. Similar to cams 200 and 204 of FIG. 16, friction reducing cams 216 and 218 may bridge across two hinge axes 28H and may be used to adjust the load that is applied by springs 72 onto friction leaves 68. The movement of cams 216 and 218 of FIG. 19 is reversed relative to that of cams 200 and 204 of FIG. 16. In particular, cams 216 and 218 may be disengaged in the folded state to transfer load from springs 72 onto friction leaves 68. Cams 216 and 218 may engage as the device approaches the fully open state to remove the load applied by springs 72 from friction leaves 68 and thereby reduce friction in hinge module 64. This reversed motion of cams 216 and 218 in the opening direction (e.g., in which cams 216 and 218 engage in the opening direction) tends to force hinge axes 28H into synchronization, which in turn helps prevent a premature drop in torque in hinge module 64. The synchronization is driven by the resistance torque to engaging cams 216 and 218, so any backlash is absorbed by an out-of-sync hinge axis 28H before cams 216 and 218 begin to engage.

To accommodate the reverse motion of cams 216 and 218, cams 216 and 218 use a movable sleeve 244 that slides along shaft 70 to load and unload friction leaves 68. When cams 216 and 218 are disengaged, cams 216 and 218 do not load sleeve 244, which in turn allows springs 72 to bypass cams 216 and 218 and apply a load to friction leaves 68 via sleeve 244. When cams 216 and 218 are engaged, cams 216 and 218 expand away from each other and lift sleeve 244 up onto a collar such as collar 250, which is fixed relative to shaft 70 using pin 228. This transfers the load from springs 72 away from friction leaves 68 and onto collar 250 to reduce friction in hinge module 64 as device 10 approaches a fully open state.

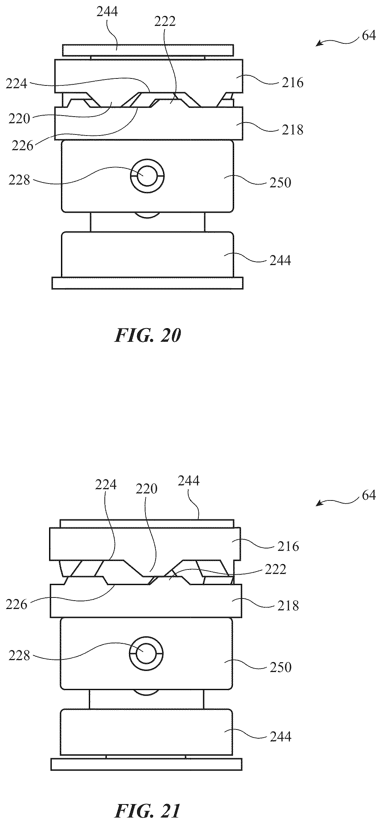

FIGS. 20 and 21 are side views of cams 216 and 218 showing how cams 216 and 218 may disengage and engage as device 10 moves between folded and flat states.

FIG. 20 shows the positions of cams 216 and 218 when device 10 is in a folded closed state (e.g., when housing portions 12-1 and 12-2 are separated by an angle of 0°). In this closed state, cams 216 and 218 are disengaged. In particular, peaks 220 of cam 216 are aligned with valleys 226 of cam 218, and the peaks 222 of cam 218 are aligned with the valleys 224 of cam 216. In this position, the load from springs 72 is transferred onto friction leaves 68 through sleeve 244 and the torque produced by hinge module 64 is relatively high. As device 10 moves from the folded closed position to a nearly fully open position, cams 216 and 218 may remain disengaged until a threshold angle is reached (e.g., 160° or other suitable threshold angle). At this angle, peaks 220 begin to align with peaks 222, and valleys 224 begin to align with valleys 226, until cams 216 and 218 reach the engaged state of FIG. 21.

In the engaged state of FIG. 21, peaks 220 of cam 216 are aligned with and contacting peaks 222 of cam 218, and valleys 224 of cam 216 are aligned with valleys 226 of cam 218. In this engaged position, the load from springs 72 is not transferred onto friction leaves 68 and is instead transferred onto collar 250, thereby reducing the torque produced by hinge module 64 compared to the torque produced by hinge module 64 when cams 216 and 218 are disengaged.

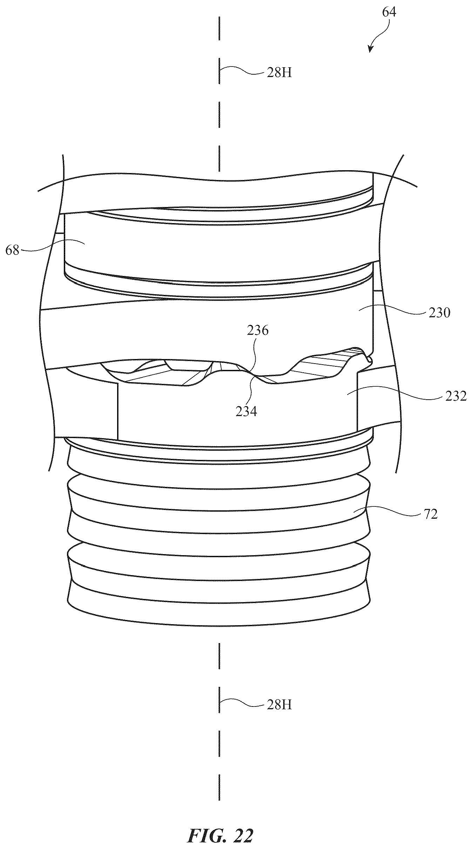

In some arrangements, it may be desirable to apply an opening torque that helps push device 10 into an open position. This can be achieved using detent cams on each hinge axis, as shown in FIG. 22. Detent cams may be used instead of or in addition to friction reducing cams.

FIG. 22 is a side view of an illustrative pair of detent cams that may be used to apply an opening torque as the device approaches a fully open position. As shown in FIG. 22, detent cams 230 and 232 may be mounted on shaft 70 between friction leaves 68 and spring 72. Similar to the friction reducing cams of FIGS. 16-21, detent cams 230 and 232 may bridge across two hinge axes 28H and may be used to adjust the load that is applied by springs 72 onto friction leaves 68. Unlike the friction reducing cams, which remove the spring load from leaves 68 entirely as device 10 approaches a fully open position, detent cams 230 and 232 may apply a torque that helps push device 10 into the fully open state when a given threshold angle is reached. In particular, when device 10 reaches a given threshold angle (e.g., when housing portions 12-1 and 12-2 are separated by a threshold angle of 160° or more, 170° or more, 150° or more, or some other angle between 110° and 180°), ramp 236 of cam 230 may be aligned with and contacting ramp 234 of cam 232, as shown in FIG. 22. Ramps 234 and 236 each have an angle that generates a reacting torque to help force hinge module 64 into the open state when this threshold angle is reached.

In the example of FIG. 22, the peaks on cams 230 and 232 have flat surfaces, which allows for constant friction across a certain range of angles during opening and closing. If desired, these flat surfaces may instead be sloped so that torque is gradually increased across that range of angles during opening and closing. This allows the torque to reach its peak within a smaller range of the hinge's motion (e.g., right before cams 230 and 232 engage). Additionally, as device 10 approaches a closed position, sloped surfaces at the peaks of cams 230 and 232 may help reduce hinge torque, which in turn helps reduce the force needed from closing magnets, latches, or other systems to help close device 10.

If desired, detent cams 230 and 232 may be configured to generate a torque and to reduce a spring load on the friction leaves to reduce friction in the hinge module. With this type of arrangement, detent cams perform both the function of a friction reducing cam (by reducing friction in hinge module 46) and a detent cam (by generating a torque). When detent cams are used in this way, there is still some residual friction in the hinge module due to the residual axial load on friction leaves 68.

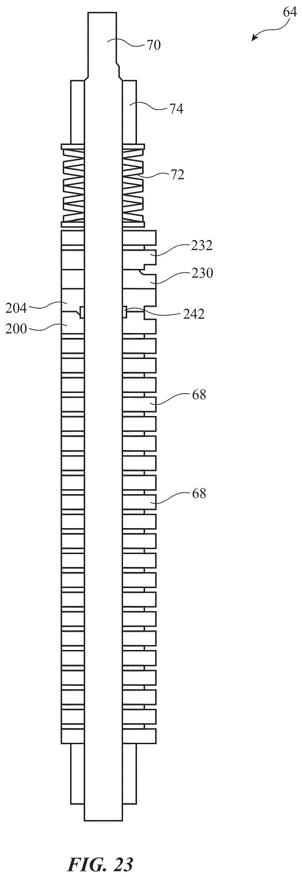

If desired, hinge module 64 may include a combination of friction reducing cams of the type described in connection with FIGS. 16-21 and detent cams of the type described in connection with FIG. 22. FIG. 23 is a side view of a portion of a hinge module that includes both friction reducing cams and detent cams.

As shown in FIG. 23, hinge module 64 may include detent cams 230 and 232 and friction reducing cams 204 and 200. Detent cams 230 and 232 may be mounted on shaft 70 between shoulder 242 and springs 72. Friction reducing cams 204 and 200 may be mounted on shaft 70 between shoulder 242 and friction leaves 68. As device 10 approaches a fully open state, friction reducing cams 200 and 204 may disengage and the spring load may be transferred onto shoulder 242. Meanwhile, detent cams 230 and 232 may remain engaged at all times and may generate an opening torque due to the angles of the ramps that are contacting each other (e.g., ramps 234 and 236 of FIG. 22).

If desired, hinge module 64 may include more than one set of detent cams on each hinge axis 28H to achieve a greater amount of opening torque. Additionally, detent cams may be configured to apply opening torque at different ranges of angles. For example, detent cams may be configured to apply an opening torque when device 10 is in a folded closed position to make device 10 easier to open. Different layers of detent cams may apply opening torque at different angles (e.g., some may apply opening torque at a folded closed state and others may apply opening torque at the fully open state). Cams such as friction reducing cams and detent cams may have cam surfaces that are molded (e.g., metal injection molded) or may have cam surfaces that are stamped, embossed, or otherwise forged into the cam. If desired, friction reducing cams and/or detent cams may be integrated into some or all of friction leaves 68.

Although the friction reducing cams of FIGS. 16-21 and the detent cams of FIGS. 22 and 23 are being used to reduce friction and/or provide an opening torque in the opening direction, it should be understood that friction reducing cams and/or detent cams may also or instead be used to reduce friction and/or provide a closing torque in the closing direction. For example, as device 10 moves from an open position to a nearly fully closed position (e.g., when the angle between housing portions 12-1 and 12-2 reaches a threshold angle close to 0° such as 3°, 5°, 10°, or some other threshold angle), friction reducing cams of the type described in connection with FIGS. 16-21 may be used to reduce load on friction leaves 68 and/or detent cams of the type described in connection with FIGS. 22 and 23 may be used to apply a closing torque in the closing direction. This may help reduce the need for closing magnets or other systems to help close device 10.

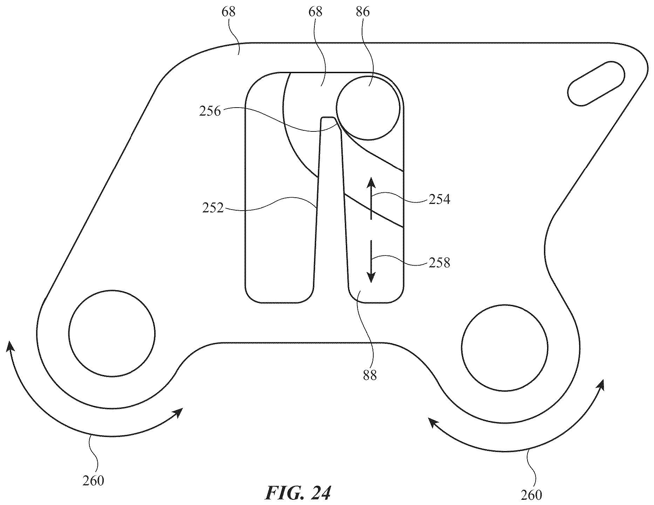

FIG. 24 is a side view of an illustrative friction leaf that may be used in hinge module 64 to help push hinge module 64 into the open state as device 10 approaches a fully flat position. In the example of FIG. 24, vertical slot 88 of friction leaf 68 includes a cantilever such as cantilever 252 that protrudes into slot 88 and that applies a spring force onto pin 86. As devices 10 opens and closes, pin 86 may slide linearly up and down within slot 88 while leaf 68 rotates in directions 260. When device 10 moves into a folded closed position, pin 86 moves downward within slot 88 in direction 258. When device 10 moves into an unfolded open position, pin 86 moves upward within slot 88 in direction 254. Cantilever 252 may have an angled surface 256 at the top that creates a bump on the side of cantilever 252. When pin 86 moves past this bump created by angled surface 256, angled surface 256 may force pin 86 into the open state.

Device 10 may be operated in a system that uses personally identifiable information. It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

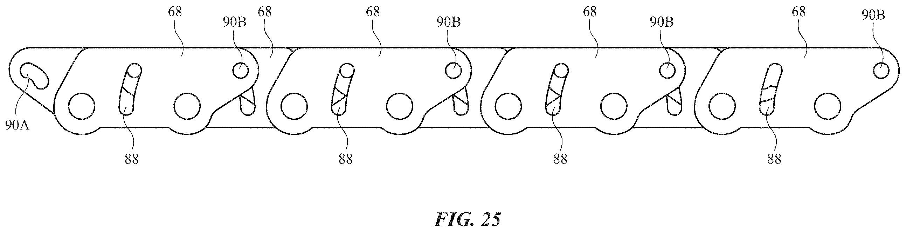

FIG. 25 is a side view of an illustrative set of friction leaves that may be used in hinge module 64 to help reduce backlash. As discussed in connection with FIGS. 11 and 12, hinge module 64 may include timing pins 86 for ensuring synchronous motion across hinge axes 28H (FIG. 13). In some arrangements, each timing pin 86 passes through three different types of slots in friction leaves 68. If desired, one or more of these three slots may instead be a press fit connection to reduce backlash from those openings. As shown in FIG. 25, for example, openings 90B in leaves 68 may be press fit holes that receive and form press fit connections with respective timing pins 86. Openings 90B may be tri-lobular shaped in order to create an interference with timing pin 86 on three sides of timing pin 86.

In addition to passing through openings 90B in a first leaf 68, each timing pin 86 may also pass through a respective opening 90A on a second leaf 68 and a respective slot 88 on a third leaf 68. Because timing pin 86 is fixed to the first leaf 68 via a press fit connection in opening 90B, timing pin 86 rotates with that first leaf 68. To accommodate this rotation, opening 90A in the second leaf may be curved and slot 88 in the third leaf may be slightly curved. The example of FIG. 25 only shows four layers of leaves 68. If desired, hinge module 64 may include more than four layers of leaves 68 and each timing pin 86 may pass through and form press fit connections with multiple leaves 68.

In accordance with an aspect of the invention, an electronic device includes a foldable housing having first and second housing portions that rotate relative to one another; a hinge coupled between the first and second housing portions, where the hinge has multiple axes of rotation and includes interdigitated leaves that each include an opening, a shaft that passes through the opening and that aligns with a respective one of the axes of rotation, and rollers coupled between the first and second housing portions; and a foldable display that overlaps the first and second housing portions and the hinge.

Optionally, the interdigitated leaves include a first group of leaves that each include a gear configured to drive synchronous motion of the first housing portion and the second housing portion.

Optionally, the interdigitated leaves include a second group of leaves that each include hard stop structures configured to impose an open position hard stop and a closed position hard stop.

Optionally, the interdigitated leaves include first and second leaves each having an additional opening and a third leaf having a vertical slot aligned with the additional openings of the first and second leaves, the hinge further includes a pin that passes through the vertical slot and the additional openings of the first and second leaves.

Optionally, the vertical slot is configured to maintain the pin at an equal distance from the adjacent axes of rotation that are located on opposing sides of the pin.

Optionally, the vertical slot has top and bottom surfaces that respectively impose an open position hard stop and a closed position hard stop.

Optionally, the interdigitated leaves are interposed between the display and the rollers.

Optionally, the additional opening is formed from first and second cantilevered arms.

Optionally, the third leaf includes first and second openings formed on opposing ends of the third leaf, the hinge further includes first and second additional pins that are respectively received within the first and second openings.

Optionally, the additional opening in the first leaf is tri-lobular shaped and forms a press fit connection with the pin, the additional opening in the second leaf is curved, and the vertical slot in the third leaf is curved.

In accordance with an aspect of the invention, a hinge assembly having multiple axes of rotation and configured to drive synchronous motion of a foldable housing includes: elongated cylinders that extend parallel to the axes of rotation; and a hinge module coupled to the elongated cylinders, where the hinge module includes a friction hinge with interdigitated leaves that rotate relative to one another about the multiple axes of rotation.

Optionally, the interdigitated leaves include first and second leaves with intermeshed gears for driving the synchronous motion of the foldable housing.

Optionally, the interdigitated leaves include third and fourth leaves with hard stop structures for preventing overtravel of the foldable housing.

Optionally, the interdigitated leaves include first and second leaves each having an opening and a third leaf having a vertical slot aligned with the openings of the first and second leaves, the hinge assembly further includes a pin that passes through the vertical slot and the openings of the first and second leaves.

Optionally, the hinge assembly further includes shafts that pass through respective sets of the interdigitated leaves, where each of the shafts is aligned with a respective one of the axes of rotation, and hourglass-shaped links that are each interposed between a respective pair of the elongated cylinders.

In accordance with an aspect of the invention, an electronic device includes a housing having first and second housing portions that fold relative to one another; and a hinge coupled between the first and second housing portions and configured to rotate about multiple axes of rotation, where the hinge includes: shafts that each extend along a respective one of the axes of rotation, pins that extend parallel to the shafts, where each of the shafts is interposed between a respective pair of the pins, and interdigitated friction fingers that respectively receive the shafts and the pins, where the interdigitated friction fingers produce torque through axial friction along the shafts.

Optionally, the interdigitated friction fingers include first and second friction fingers each having an opening and a third friction finger having a vertical slot aligned with the openings of the first and second friction fingers, where a respective one of the pins passes through the openings of the first and second friction fingers and the vertical slot of the third friction finger.

Optionally, the vertical slot is configured to maintain the respective one of the pins at an equal distance from the adjacent axes of rotation that are located on opposing sides of the respective one of the pins.

Optionally, the vertical slot has top and bottom surfaces that respectively impose an open position hard stop and a closed position hard stop.

Optionally, the electronic device further includes a foldable display coupled to the housing and rollers coupled between the first and second housing portions and extending parallel to the axes of rotation, where the interdigitated friction fingers are interposed between the foldable display and the rollers.

Optionally, the electronic device further includes a spring on each of the shafts that is configured to apply a load to the interdigitated friction fingers and friction reducing cams on each of the shafts that transfer the load away from the interdigitated friction fingers as the electronic device approaches an open state in which the first and second housing portions are separated by an angle of 180 degrees.

Optionally, each of the shafts has a shoulder and the friction reducing cams transfer the load onto the shoulder as the electronic device approaches the open state.

Optionally, the electronic device further includes a sleeve and a collar on each of the shafts, where the sleeve is movable relative to the shaft and the collar is fixed relative to the shaft, and where the friction reducing cams move the sleeve onto the collar to transfer the load onto the collar as the electronic device approaches the open state.

Optionally, the electronic device further includes detent cams on each of the shafts that are configured to generate a torque that pushes the electronic device into an open state in which the first and second housing portions are separated by an angle of 180 degrees.

Optionally, at least some of the interdigitated friction fingers include a slot and a cantilever that protrudes into the slot, where the cantilever has an angled surface that applies a force to the pin to push the electronic device into an open state in which the first and second housing portions are separated by an angle of 180 degrees.

The foregoing is merely illustrative and various modifications can be made to the described embodiments. The foregoing embodiments may be implemented individually or in any combination.

## Claims

1. An electronic device, comprising:
a housing having first and second housing portions that fold relative to one another; and
a hinge coupled between the first and second housing portions and configured to rotate about multiple axes of rotation, wherein the hinge comprises:
shafts that each extend along a respective one of the axes of rotation;
pins that extend parallel to the shafts, wherein each of the shafts is interposed between a respective pair of the pins; and
interdigitated friction fingers that respectively receive the shafts and the pins, wherein the interdigitated friction fingers produce torque through axial friction along the shafts.

2. The electronic device defined in claim 1 wherein the interdigitated friction fingers comprise:
first and second friction fingers each having an opening; and
a third friction finger having a vertical slot aligned with the openings of the first and second friction fingers, wherein a respective one of the pins passes through the openings of the first and second friction fingers and the vertical slot of the third friction finger.

3. The electronic device defined in claim 2 wherein the vertical slot is configured to maintain the respective one of the pins at an equal distance from the adjacent axes of rotation that are located on opposing sides of the respective one of the pins.

4. The electronic device defined in claim 2 or claim 3 wherein the vertical slot has top and bottom surfaces that respectively impose an open position hard stop and a closed position hard stop.

5. The electronic device defined in any preceding claim further comprising:
a foldable display coupled to the housing; and
rollers coupled between the first and second housing portions and extending parallel to the axes of rotation, wherein the interdigitated friction fingers are interposed between the foldable display and the rollers.

6. The electronic device defined in any preceding claim further comprising:
a spring on each of the shafts that is configured to apply a load to the interdigitated friction fingers; and
friction reducing cams on each of the shafts that transfer the load away from the interdigitated friction fingers as the electronic device approaches an open state in which the first and second housing portions are separated by an angle of 180 degrees.

7. The electronic device defined in claim 6 wherein each of the shafts has a shoulder and wherein the friction reducing cams transfer the load onto the shoulder as the electronic device approaches the open state.

8. The electronic device defined in claim 6 further comprising a sleeve and a collar on each of the shafts, wherein the sleeve is movable relative to the shaft and the collar is fixed relative to the shaft, and wherein the friction reducing cams move the sleeve onto the collar to transfer the load onto the collar as the electronic device approaches the open state.

9. The electronic device defined in any preceding claim further comprising:
detent cams on each of the shafts that are configured to generate a torque that pushes the electronic device into an open state in which the first and second housing portions are separated by an angle of 180 degrees.

10. The electronic device defined in any preceding claim wherein at least some of the interdigitated friction fingers include a slot and a cantilever that protrudes into the slot, wherein the cantilever has an angled surface that applies a force to the pin to push the electronic device into an open state in which the first and second housing portions are separated by an angle of 180 degrees.

11. The electronic device defined in any preceding claim further comprising:
elongated cylinders that extend parallel to the axes of rotation, wherein the hinge is coupled to the elongated cylinders.

12. The electronic device defined in claim 11 further comprising:
hourglass-shaped links that are each interposed between a respective pair of the elongated cylinders.

13. The electronic device defined in claim 1 wherein the interdigitated friction fingers comprise:
first and second friction fingers with intermeshed gears for driving the synchronous motion of the first and second housing portions.

14. The electronic device defined in claim 13 wherein the interdigitated friction fingers comprise:
third and fourth friction fingers with hard stop structures for preventing overtravel of the first and second housing portions.

15. The electronic device defined in claim 1 wherein the interdigitated friction fingers comprise:
first and second friction fingers each having an opening; and
a third friction finger having a vertical slot aligned with the openings of the first and second friction fingers, wherein a given one of the pins forms a press fit connection with the opening in the first friction finger.
